Europäisches Patentamt

European Patent Office

Office européen des brevets

(11) Publication number: **0 372 836**
**A2**

# EUROPEAN PATENT APPLICATION

(21) Application number: **89312502.1**

(22) Date of filing: **30.11.89**

(51) Int. Cl.5: **H01L 21/321**

(30) Priority: **09.12.88 US 283110**

(43) Date of publication of application:
**13.06.90 Bulletin 90/24**

(84) Designated Contracting States:
**DE ES FR GB IT NL**

(71) Applicant: **AMERICAN TELEPHONE AND TELEGRAPH COMPANY**
**550 Madison Avenue**
**New York, NY 10022(US)**

(72) Inventor: **Huttemann, Robert Donald**
**5583 Princeton Road**
**Macungie Pennsylvania 18062(US)**
Inventor: **Tsai, Nun-Sian**
**3643 Valley Forge Road**
**Allentown Pennsylvania 18104(US)**

(74) Representative: **Johnston, Kenneth Graham et al**
**AT&T (UK) LTD. AT&T Intellectual Property Division 5 Mornington Road ·**
**Woodford Green Essex, IG8 OTU(GB)**

(54) **Etching of integrated-circuit device metallization and resulting device.**

(57) Prior to photolithographic patterning, metallization layers deposited in the manufacture of integrated-circuit devices preferably are planarized by over-all etching. In the interest of monitoring such etch process - for the sake of leaving a residual layer having precisely specified thickness, a metallization layer preferably has sublayered structure whose removal can be optically monitored sublayer by sublayer, e.g., by so-called laser trace.

EP 0 372 836 A2

## ETCHING OF INTEGRATED-CIRCUIT DEVICE METALLIZATION AND RESULTING DEVICE

### Technical Field

The invention relates to semiconductor integrated-circuit devices comprising a metal layer.

### Background of the Invention

Semiconductor integrated-circuit device chips typically incorporate patterned metallization layers or films, with patterns including so-called runners which serve to connect devices, as well as pads for providing electrical contact points. At least in part, such layers are deposited on a dielectric material and, typically, such material has openings (windows, holes) through which the metallization material makes contact with semiconductor material. Where such openings are present there is concern not only with adequate filling of openings with metal, but also with the production of a metal deposit having a sufficiently flat surface over-all, flatness being desirable for subsequent photolithographic patterning and further layer deposition. Typically in this regard, excess metal is deposited, and the deposit is planarized by etching.

In many instances of planarization it is desirable to etch a deposited metal layer down to nothing or almost nothing while leaving metal "plugs" in holes unaffected. Such planarization etching, however, calls for control of the etching process so as to prevent inadvertent exposure of material underlying the metal ("punch-through"), and to prevent removal of metal deposited into holes. For discussions in this respect see, e.g., G. C. Smith, "CVD Tungsten Contact Plugs by In-situ Deposition and Etch-back", *Proceedings, Second International IEEE VLSI Multilevel Interconnect Conference*, Santa Clara, 1985, pp. 350-356 and R. J. Saia et al., "Plasma Etching Methods for the Formation of Planarized Tungsten Plugs Used in Multilevel VLSI Metallizations", *Journal of the Electrochemical Society: Solid State Science and Technology, Vol. 135(1988), pp. 936-940.*

It would be desirable to monitor the progress of etching in a fashion similar to established practice in the case of semiconductor and dielectric layers (see, e.g., the book by S. M. Sze, ed., *VLSI Technology*, Second Edition, McGraw-Hill, 1988, p. 221, as well as U. S. patent 4,462,860, issued July 31,1984 to C. R. Szmanda), namely by monitoring light reflected from a surface being etched. As such monitoring has been based on optical interference between light reflected from the surface being etched and light reflected from an underlying reference surface, sufficient transparency of layer material has been required, and metal layers have been considered as not amenable to such monitoring due to their high reflectivity and opaqueness.

### Summary of the Invention

In the manufacture of semiconductor integrated-circuit devices, the invention provides for optical monitoring of the progress of etching of a metallization layer as facilitated by sublayered structure of such layer. Preferred sublayered structure may be obtained in the course of layer deposition, e.g., by periodic inclusion of sublayers of a material different from a primary metallization material; such structure may also be based on varying morphology in a homogeneous or essentially homogeneous material.

Etching may proceed while visible or invisible electromagnetic radiation having a suitable frequency component is incident on the layer being etched; use of a laser optical source is considered particularly advantageous for this purpose. Radiation reflected from (or transmitted by) the layer being etched is monitored for variations such as, typically, variations in intensity, such variations being correlated with the progress of etching through the deposited structure. Monitoring typically involves the use of an optical sensor which produces an electrical signal, and such signal may be received by a sensor device under computer control in an automated device processing facility.

### Brief Description of the Drawing

FIG. 1 schematically shows an MOS integrated-circuit device prior to preferred processing in accordance with the invention;

FIG. 2 schematically shows the device of FIG. 1 after exemplary preferred processing in accordance with the invention;

FIG. 3 schematically shows the device of FIG. 2 after further layer deposition and etching; and

FIG. 4 graphically depicts intensity of light reflected from a metallization structure undergoing preferred processing in accordance with the invention.

### Detailed Description

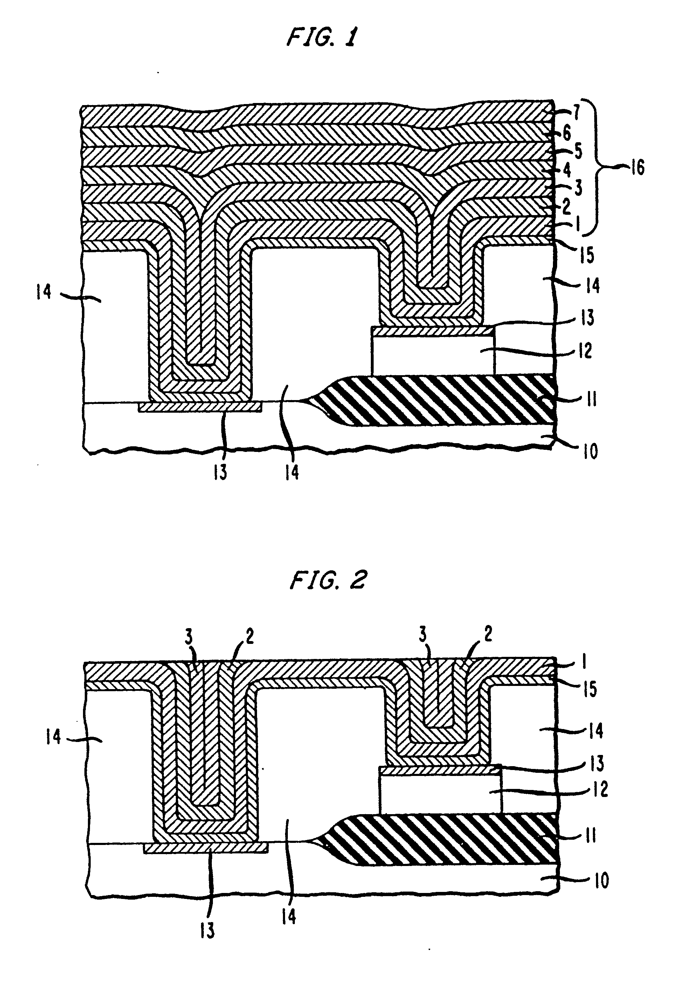

FIG. 1 shows substrate 10, field oxide layer 11, polysilicon layer 12, titanium silicide layer 13, silicon dioxide layer 14, titanium-tungsten layer 15, and tungsten layer 16 comprising sublayers 1 through 7 - the number of sublayers more generally being chosen to achieve desired over-all layer thickness.

FIG. 2 shows most of the structure of FIG. 1, except that the bulk of layer 16 has been etched away, leaving a planarized surface having the thickness of the remaining sublayer 1.

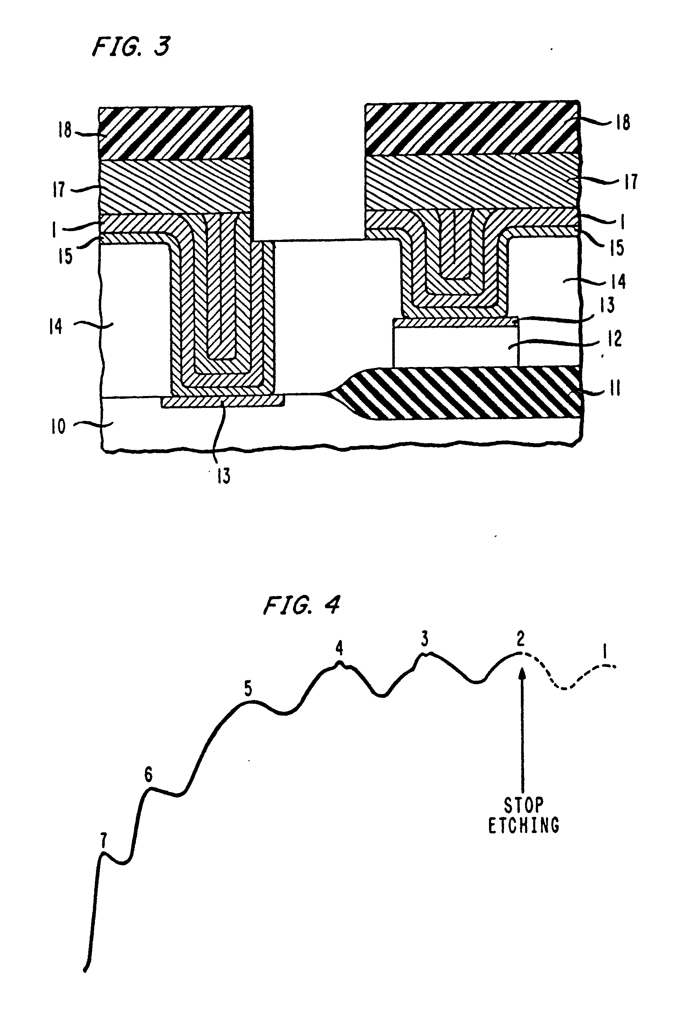

FIG. 3 shows the structure of Fig. 2 with an additional aluminum layer 17 deposited on the tungsten layer 16, and a photoresist layer 18 on the aluminum layer 17, the combined layers 17, 16 and 15 having been pattern-etched, e.g., by sputter etching.

FIG. 4 shows a so-called laser trace as obtained during exemplary processing in accordance with a preferred embodiment of the invention, graphically depicting intensity of reflected laser light as a function of time during etching. Due to the sublayered structure (sublayers 1 through 7 in FIG. 1) of layer 16, laser trace during etching yields peaks and valleys of reflected light intensity as associated with different reflectivity of etched bulk sublayer material as compared with reflectivity at the interface of sublayers. By counting peaks or valleys it is possible to follow the progress of sublayer removal, permitting to terminate etching after removal of any specified number of sublayers. For example, etching may stop at the point where a single sublayer remains on the dielectric.

While monitoring may be understood in terms of the observation of changes in reflectivity as different materials are being exposed in the course of etching, optical monitoring based on other physical effects is not precluded. For example, differences in reflectivity may occur also in a chemically essentially homogeneous material which has layered grain structure - as renucleation interfaces tend to be smoother than intermediary surfaces exposed by etching. (For a preferred method of producing renucleated layered structure see the above-identified cross-referenced patent application which is incorporated herein by reference.) Also, monitoring may be of other radiation attributes such as, e.g., polarization; and, especially in the case of sublayered structure having essentially constant sublayer thickness, optical interference patterns or "fringes" may be observed.

As described above, preferred processing of the invention can be used in the manufacture of MOS devices, its application to other devices and device structures not being precluded. For example, devices having three-dimensional structure may include a plurality of metallizations which are separated by semiconductor and dielectric materials, and preferred processing in accordance with the invention can be applied to any or all such layers. Also, while tungsten represents an increasingly important metallization material at least for deposition directly on a dielectric, preferred processing of the invention may be applied to other types of metal layers such as, e.g., layers of aluminum, titanium, tantalum, cobalt, and molybdenum as used in semiconductor integrated-circuit manufacture, and the use of alloys and of sublayers having different compositions is not precluded. Also, semiconductor devices need not be silicon-based, and preferred processing in accordance with the invention can be applied also to metallizations in compound-semiconductor devices as based, e.g., on Group III-V and Group II-VI materials.

## Claims

1. A method for making a semiconductor integrated-circuit device, which includes a supported metallization layer, comprising the steps of:
depositing a layer of a first metal, said layer having sublayered structure,
exposing at least a portion of said layer to an etching agent while at least a subregion of said portion is exposed to electromagnetic radiation, and
monitoring electromagnetic radiation emanating from said structure in response to exposure to said electromagnetic radiation.

2. The method of claim 1 in which said emanating radiation has been reflected by said structure.

3. The method of claim 1 in which said emanating radiation has been transmitted by said structure.

4. The method of claim 1 in which emanating radiation is monitored for intensity variations.

5. The method of claim 1 in which exposure to said etching agent is discontinued based on variations in said emanating radiation.

6. The method of claim 5 in which said exposure is discontinued so as to leave a predetermined number of sublayers of said structure essentially unetched.

7. The method of claim 6 in which exactly one sublayer of said structure remains essentially unetched.

8. The method of claim 5, resulting in an essentially planar etched surface.

9. The method of claim 1 in which said electromagnetic radiation is produced by a laser.

10. The method of claim 1 in which said sublayered structure is such that sublayers have essentially the same thickness.

11. The method of claim 1 in which said sublayered structure comprises layers having different compositions.

12. The method of claim 1 in which said sublayered structure comprises renucleated sublayers.

13. The method of claim 1, further comprising patterning said metal layer.

14. The method of claim 13 in which patterning is by photolithographic means.

15. The method of claim 1 in which said metal consists essentially of tungsten.

16. The method of claim 1 in which said metal consists essentially of aluminum.

17. The method of claim 1, further comprising additional metal deposition after exposing said layer to an etching agent.

18. The method of claim 17 in which said additional metal is different from said first metal.

19. The method of claim 17 in which said first metal consists essentially of tungsten and said additional metal consists essentially of aluminum.

20. A semiconductor integrated-circuit device comprising a supported metallization layer, said metallization layer having sublayered structure, a portion of said metallization layer having been removed by etching so as to leave at least one sublayer of said metallization layer essentially unetched.

21. The device of claim 20 in which said metallization layer is patterned for interconnection.

## FIG. 1

## FIG. 2

## FIG. 3

## FIG. 4